Europäisches Patentamt

European Patent Office

Office européen des brevets

(19)

(11) Numéro de publication: **0 330 113**
**A1**

## (12) DEMANDE DE BREVET EUROPEEN

(21) Numéro de dépôt: **89102886.2**

(22) Date de dépôt: **20.02.89**

(51) Int. Cl.4: **H01B 1/22** , **H01B 1/24** ,
**H01B 1/20**

(30) Priorité: **26.02.88 FR 8802519**

(43) Date de publication de la demande:
**30.08.89 Bulletin 89/35**

(84) Etats contractants désignés:
**CH DE GB IT LI NL**

(71) Demandeur: **ASULAB S.A.**
**Faubourg du Lac 6**
**CH-2502 Bienne(CH)**

(72) Inventeur: **Cognard, Jacques**
**Chemin de Serroue 17**
**CH-2006 Neuchâtel(CH)**

(74) Mandataire: **de Montmollin, Henri et al**
**ICB Ingénieurs Conseils en Brevets SA**
**Passage Max. Meuron 6**
**CH-2001 Neuchâtel(CH)**

(54) **Mélange adhésif électriquement conducteur.**

(57) Le mélange adhésif conducteur comporte des particules conductrices disposées dans un matériau de base thermoplastique qui ne présente aucune transition entre deux de ses états solides accompagnée d'une variation notable de son volume spécifique à une température inférieure à 85°C.

Les liaisons mécaniques et électriques entre deux sous-ensembles réalisées à l'aide de ce mélange adhésif conducteur supportent sans dommage le stockage à + 75°C pendant 24 heures et cent variations cycliques de température entre - 55°C et + 85°C.

EP 0 330 113 A1

# MELANGE ADHESIF ELECTRIQUEMENT CONDUCTEUR

La présente invention a pour objet un mélange adhésif électriquement conducteur comportant un matériau de base adhésif thermoplastique et des particules conductrices disposées dans ledit matériau de base.

Une couche mince d'un tel mélange adhésif est assez couramment utilisée pour relier mécaniquement et électriquement deux sous-ensembles électriques ou électroniques comportant chacun un substrat isolant, souple ou rigide, et une ou plusieurs pistes conductrices disposées sur ce substrat.

Les deux substrats se font partiellement face de manière qu'au moins une partie de chacune des pistes conductrices portées par l'un d'entre eux soit située en regard d'une partie de la piste conductrice correspondante portée par l'autre.

Le matériau de base du mélange adhère aux deux substrats dans la partie où ils se font face et assure la liaison mécanique entre les deux sous-ensembles.

Dans certains cas, l'épaisseur de la couche de mélange adhésif et les dimentions des particules conductrices sont telles qu'une de ces dernières, au moins, est directement en contact avec l'une des pistes de l'un des substrats et avec la piste correspondante de l'autre substrat et assure la liaison électrique entre ces pistes.

Dans d'autres cas, la conduction électrique est assurée par plusieurs particules conductrices formant une sorte d'empilement entre les pistes correspondantes.

Dans tous les cas, les dimensions des particules conductrices et leur concentration dans la matériau adhésif de base sont choisies de manière qu'il n'y ait aucun risque de court-circuit entre deux pistes adjacentes d'un même substrat.

Une telle liaison mécanique et électrique de deux sous-ensembles à l'aide d'un adhésif conducteur se prête particulièrement bien à la fabrication en grandes séries car elle est très facile à réaliser et son prix de revient est très faible.

Selon les cas, l'ensemble formé par les deux sous-ensembles reliés de la manière décrite ci-dessus peut constituer un appareil électrique ou électronique complet. Cet ensemble peut aussi être associé à d'autres ensembles ou sous-ensembles pour former un appareil plus complexe.

A titre d'exemple non limitatif, un des sous-ensembles peut être une cellule d'affichage à cristaux liquides comportant deux plaques de verre dont l'une porte des pistes conductrices reliées aux électrodes de commande de la cellule et constitue le premier substrat.

L'autre sous-ensemble peut alors comporter un circuit intégré destiné à commander la cellule d'affichage et un circuit imprimé souple ou rigide comprenant une feuille en un matériau isolant constituant le deuxième substrat et portant des pistes conductrices destinées à relier électriquement le circuit intégré à la cellule d'affichage.

Il faut noter ici qu'il existe des mélanges adhésifs électriquement conducteur dont le matériau de base est thermodurcissable, ces mélanges pouvant également être utilisés pour relier mécaniquement et électriquement deux sous-ensembles du genre de ceux qui ont été décrits ci-dessus. Ces mélanges adhésifs ne seront cependant pas décrits ici car ils ne sont pas concernés par la présente invention.

Il existe de nombreux documents qui décrivent des mélanges adhésifs électriquement conducteurs comportant un matériau de base thermoplastique.

Ainsi, dans le brevet U5-A-3 359 145, le matériau de base est un polymère vinylique ou un polyamide.

Dans le brevet US-A-4 113 981, le matériau de base est un polyéthylène, une résine acrylique ou, de nouveau, un polyamide.

Dans le brevet U5-A-4 457 796, le matériau de base est une résine époxyde.

Ces documents mentionnent également un assez grand nombre de genre de particules conductrices qui peuvent être ajoutées à ces matériaux de base pour former les mélanges adhésifs conducteurs.

Le brevet US-A-3 359 145 mentionne des particules ferromagnétiques.

Le brevet US-A-4 113 981 mentionne des poudres de carbone, de carbure de silicium ou de métaux tels que l'argent, l'or, le palladium, le nickel ou l'indium.

Le brevet U5-A-4 457 796 mentionne des fibres de carbone.

Les entreprises ou les administrations qui achètent des appareils électroniques pour les incorporer dans leurs propres produits ou pour les utiliser tels quels posent très souvent comme condition à leur achat que ces appareils fonctionnent encore correctement après avoir été soumis à diverses épreuves plus ou moins sévères selon les conditions réelles d'emploi de ces appareils.

Parmi les épreuves que doivent surmonter les appareils destinés à fonctionner dans un environnement industriel normal, c'est-à-dire la grande majorité des appareils, figurent très souvent celles qui consistent à les stocker pendant au moins 24 heures à une température de + 75°C, et à les soumettre à des températures variant cycliquement cent fois de suite entre - 55°C et + 85°C.

Ces épreuves sont celles qui sont prescrites par la norme MIL-STD 883 C, méthode 10.08.2, test A et méthode 10.10.6, test A respectivement.

La norme MIL-STD 883 C est l'une des nombreuses normes établies par les services compétents de l'armée des Etats-Unis d'Amérique.

L'expérience montre que, lorsqu'un appareil comportant deux sous-ensembles reliés mécaniquement et électriquement par une couche d'un mélange adhésif tel que ceux qui sont décrits dans les documents mentionnés ci-dessus est soumis aux épreuves prescrites par ces normes, un certain nombre des liaisons électriques normalement assurées par les particules conductrices du mélange adhésif s'interrompent déjà, dans la plupart des cas, après quelques uns des cycles de température et/ou après quelques heures, voire même quelques minutes, passées à la température de stockage si des moyens auxiliaires, tels que des étriers, des boulons, etc..., ne sont pas prévus pour maintenir fermement les deux substrats l'un contre l'autre. Il est évident que de tels moyens auxiliaires compliquent et renchérissent sérieusement la réalisation de la liaison mécanique et électrique des deux sous-ensembles..

On pourrait penser qu'il suffit de choisir comme matériau de base du mélange adhésif un matériau ayant une température de fusion supérieure à la température maximale à laquelle l'appareil est soumis pendant ces épreuves pour que les interruptions des liaisons électriques mentionnées ci-dessus ne se produisent plus.

Or on a constaté que ces interruptions se produisent même avec des matériaux adhésifs dont la température de fusion est nettement supérieure à cette température maximale.

Le but de la présente invention est de proposer un mélange adhésif conducteur qui ne présente pas l'inconvénient mentionné ci-dessus, c'est-à-dire un mélange adhésif conducteur dont l'emploi garantit que toutes les liaisons électriques entre les deux sous-ensembles qu'il relie sont maintenues après que l'appareil comportant ces sous-ensembles a été soumis à des essais de température semblables à ceux qui sont prescrits par la norme MIL-5TD 883 C, méthodes 10.08.2 test A et 10.10.6 test A, sans qu'il soit nécessaire de prévoir des moyens auxiliaires destinés à maintenir les substrats de ces sous-ensembles l'un contre l'autre.

Ce but est atteint par le mélange adhésif conducteur revendiqué, grâce au fait que le matériau de base de ce mélange est un matériau adhésif thermoplastique qui ne présente aucune transition entre deux états solides accompagnée d'une variation notable de son volume spécifique à une température inférieure à 85°C.

Il est bien connu que, selon sa température, un matériau thermoplastique peut se présenter dans divers états.

A basse température, un tel matériau se présente généralement dans un premier état solide, dit état vitreux, dans lequel il est dur et cassant.

A plus haute température, un tel matériau se présente généralement dans un deuxième état solide, dit état caoutchouteux dans lequel il est relativement mou et élastique.

Enfin, à une température encore plus élevée, un tel matériau se présente dans un état fluide dans lequel il est liquide ou pâteux.

La transition entre les deux états solides mentionnés ci-dessus se produit progressivement autour d'une température généralement appelée température de transition vitreuse et désignée par $T_g$.

La valeur de cette température $T_g$ dépend évidemment de la nature du matériau thermoplastique considéré.

Certains matériaux thermoplastiques, notamment les copolymères blocs séquencés, peuvent présenter à basse température un autre état solide, dans lequel certains des blocs que comportent les molécules du matériau sont agglomérés et forment des domaines cristallins noyés dans une masse amorphe constituée par les autres blocs que comportent ces molécules.

A une température plus élevée, ces matériaux se présentent dans un état qui peut être vitreux ou caoutchouteux selon les cas, et dans lequel plus aucun domaine cristallin n'existe.

La transition entre l'état où ces domaines cristallins existent et celui où ces domaines cristallins n'existent plus se produit autour d'une température qui dépend aussi de la nature du matériau.

Les transitions entre les divers états solides d'un matériau thermoplastique qui ont été mentionnées ci-dessus peuvent être mises en évidence en mesurant la valeur en fonction de la température de certaines caractéristiques physiques de ce matériau telles que sa constante diélectrique, sa chaleur spécifique, etc.... Ces caractéristiques présentent généralement une variation bien marquée à chaque température de transition, que cette dernière soit une transition vitreuse ou une transition d'une autre nature.

Dans la suite de cette description, ces transitions entre deux états solides seront appelées transitions solides, et la ou les températures auxquelles elles se produisent seront désignées par $T_t$.

Suite à de nombreux essais la déposante a constaté que dans les matériaux thermoplastiques qui ne présentent qu'une seule transition solide, celle-ci est généralement accompagnée d'une variation notable du volume spécifique du matériau, cette variation étant une augmentation de ce volume spécifique lorsque la température du matériau passe par la température de transition en croissant.

En outre, dans certains matériaux thermoplastiques présentant plusieurs transitions solides, une seule des ces transitions est accompagnée d'une variation notable du volume spécifique du matériau. Cette transition solide est généralement celle qui se produit à la température de transition $T_t$ la plus élevée.

Dans ces derniers matériaux thermoplastiques, l'autre ou les autres transitions solides ne sont généralement accompagnées d'aucune variation du volume spécifique du matériau, ou seulement d'une variation négligeable de ce volume spécifique.

Lorsqu'un matériau thermoplastique est simplement utilisé pour relier mécaniquement deux pièces quelconques, la variation de son volume spécifique mentionnée ci-dessus n'a généralement pas d'effets néfastes, car elle n'est pas très importante et ne s'accompagne pas de tensions internes qui pourraient conduire à une rupture de la liaison mécanique des deux pièces. En outre, cette variation de volume spécifique est réversible.

La déposante a par contre constaté que cette variation de volume spécifique accompagnant une transition solide d'un matériau thermoplastique est probablement la cause des interruptions qui se produisent dans les liaisons électriques entre deux sous-ensembles reliés mécaniquement et électriquement par une couche d'un mélange adhésif conducteur dont ce matériau thermoplastique constitue la base.

Le mécanisme exact de ces interruptions de liaisons électriques ne peut pas encore être expliqué complètement, car contrairement à la variation de volume spécifique mentionnée ci-dessus, une telle interruption n'est généralement pas réversible. En effet, si une liaison électrique s'interrompt pendant une augmentation de la température, elle ne se rétablit généralement pas lorsque la température diminue.

Au cours des essais mentionnés ci-dessus, la déposante a constaté que si le matériau de base d'un mélange adhésif conducteur est un matériau thermoplastique qui ne présente aucune transition solide accompagnée d'une variation notable de son volume spécifique à des températures inférieures à 85°C, un ensemble formé de deux sous-ensembles reliés mécaniquement et électriquement par une couche de ce mélange adhésif conducteur supporte parfaitement les essais de température mentionnés ci-dessus, c'est- à-dire qu'aucune des liaisons électriques entre les deux sous-ensembles ne s'interrompt lorsque cet ensemble est stocké à 75°C pendant 24 h et/ou lorsque sa température est modifiée cent fois de suite de - 55°C à +85°C.

Le tableau ci-dessous donne à titre d'exemple non limitatif le nom commercial, le fournisseur et le genre d'un certain nombre de matériaux thermoplastique qui remplissent la condition ci-dessus. Le tableau indique également pour chacun de ces matériaux la tempé rature $T_t$ à laquelle se produit la première transition solide accompagnée d'une variation notable de son volume spécifique.

| Nom commercial | Fournisseur | Genre | $T_t$ (°C) |
|---|---|---|---|
| APE 1-9300 | Bayer AG, Leverkusen, Allemagne | Polyester aromatique | 190 |
| Arylon 402 FR | Dupont de Nemours (Suisse), Genève, Suisse | Polyarylate | 174 |
| Udel 1700 | Union Carbide Europe, Genève, Suisse | Polysulfone | 140 |
| Victrex 41006 | ICI Imperial Chemical Industries, Runcorn, Gde Bretagne | Polyéther sulfone | 225 |
| Victrex 4506 | ICI Imperial Chemical Industries, Runcorn, Gde Bretagne | Polyéther éthercétone | 138 |
| TR 55 | Ems Chemie, Ems, Suisse | Polyamide 5.5 | 160 |
| Griltex XE 3038 | Ems Chemie, Ems, Suisse | Polyamide amorphe | 140 |
| Griltex XE 3098 | Ems Chemie, Ems, Suisse | Polyamide amorphe | 110 |
| Technomelt QR 116 | Henkel Cie AG Düsseldorf, Allemagne | Polyuréthane | 130 |

Il est évident que les mélanges adhésifs conducteurs selon la présente invention peuvent comporter n'importe lesquelles des particules conductrices bien connues des spécialistes, notamment celles qui sont décrites dans les documents mentionnés ci-dessus. La déposante a obtenu d'excellents résultats avec des particules conductrices constituées par des fibres de carbone de quelques micromètres de diamètre, ainsi

4

qu'avec des particules de cuivre, d'or ou d'argent ayant des dimensions maximales de quelques micromètres également.

Il est également évident que l'emploi d'un mélange adhésif conducteur selon l'invention est tout aussi simple et présente les mêmes avantages que celui d'un mélange adhésif connu.

Les différents procédés qui peuvent être mis en oeuvre pour réaliser une liaison mécanique et électrique entre deux sous-ensembles à l'aide d'un mélange adhésif conducteur selon l'invention sont en outre très semblables à ceux qui sont utilisés pour mettre en oeuvre un mélange adhésif conducteur connu. Ces procédés ne seront donc pas décrits ici.

## Revendications

1. Mélange adhésif électriquement conducteur comportant un matériau de base adhésif thermoplastique et des particules conductrices disposées dans ledit matériau de base, caractérisé par le fait que ledit matériau de base ne présente aucune transition entre deux états solides accompagnée d'une variation notable de son volume spécifique à une température inférieure à 85° C.

2. Mélange adhésif selon la revendication 1, caractérisé par le fait que ledit matériau de base est un polyester aromatique.

3. Mélange adhésif selon la revendication 1, caractérisé par le fait que ledit matériau de base est un polyarylate.

4. Mélange d'adhésif selon la revendication 1, caractérisé par le fait que ledit matériau de base est un polysulfone.

5. Mélange adhésif selon la revendication 1, caractérisé par le fait que ledit matériau de base est un polyéther sulfone.

6. Mélange adhésif selon la revendication 1, caractérisé par le fait que ledit matériau de base est un polyéther éther-cétone.

7. Mélange adhésif selon la revendication 1, caractérisé par le fait que ledit matériau de base est un polyamide 5.5.

8. Mélange adhésif selon la revendication 1, caractérisé par le fait que ledit matériau de base est un polyamide amorphe.

9. Mélange adhésif selon la revendication 1, caractérisé par le fait que ledit matériau de base est un polyuréthane.

Office européen
des brevets

RAPPORT DE RECHERCHE EUROPEENNE

Numero de la demande

EP 89 10 2886

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 171 157 (STAUFFER) <br> * Revendications 1-8 * <br> ----- | 1 | H 01 B 1/22 <br> H 01 B 1/24 <br> H 01 B 1/20 |

**DOMAINES TECHNIQUES RECHERCHES (Int. Cl.4)**

H 01 B 1/00

Le présent rapport a été établi pour toutes les revendications

| Lieu de la recherche | Date d'achèvement de la recherche | Examinateur |
|---|---|---|
| LA HAYE | 17-05-1989 | DROUOT M.C. |